# EUROPEAN PATENT SPECIFICATION

(11) **EP 0 697 767 B1**
(45) Date of publication and mention of the grant of the patent: **06.03.2002**
(21) Application number: 94305829.7
(22) Date of filing: 05.08.1994
(51) Int. Cl.: H03K 5/00, G06F 1/12

(54) **Accelerator**
Akzelerator
Accélérateur

(43) Date of publication of application: 21.02.1996
(73) Proprietor: MELCO INC., Nagoya-shi, Aichi-ken 460 (JP)
(72) Inventor: Saito, Shinsuke, Nagoya-shi, Aichi-ken 460 (JP); Katagiri, Shigeru, Nagoya-shi, Aichi-ken 460 (JP)
(74) Representative: Tomlinson, Kerry John

(56) References cited:
- EP-A- 0 142 440
- EP-A- 0 551 514
- EP-A- 0 576 711
- GB-A- 2 262 415
- C't-Magazin für Computertechnik, 1991, nr. 7, pp. 55-57, Heise GmbH & Co, Hannover, Germany; Schnurer: 'Die grosse Verlade'.
- IBM TECHNICAL DISCLOSURE BULLETIN., vol.33, no.3B, August 1990, NEW YORK US pages 112 - 113 '32-Bit Memory Subsystem Supports Intel 80386 And 80386SX Processors'
- BYTE, April 1994, special report: 'Intel, TI Show Off the 486DX'; downloaded from http://www.byte.com/art/9404/sec8/art2.htm on 3.5.99.
- PC-World, November 1992, pp. 159-162, Goodwin et al: 'Best Choice: etc...'

## Description

The present invention relates to an accelerator to speed up a computer, and more specifically to an accelerator working in place of a CPU on a motherboard to improve the processing speed.

As generally known, an accelerator may be attached to a computer to work in place of a CPU mounted on a motherboard and driven by a predetermined clock frequency (for example, 16 MHz) so as to speed up the processing of the computer. Such an accelerator includes a high-speed CPU (for example, driven by a clock frequency of 48 MHz) working in place of a low-speed CPU on the motherboard to realize the high-speed processing. The accelerator may be attached directly to a CPU socket where the low-speed CPU is originally mounted, or mounted on a socket for an arithmetic processor or an exclusive socket for an accelerator. Such a conventional accelerator, however, only speeds up internal operations of the CPU while substantially not speeding up data exchange between the CPU and a ROM or a RAM on the motherboard operated at a low speed. Improved accelerators have been proposed for speeding up the whole processing. Examples of the improved accelerators include one that mounts a high-speed memory and that has a cache memory inside the CPU to reduce the number of accesses to a low-speed element.

For the access of the CPU on the accelerator to memories on the motherboard, the accelerator should be driven by a clock synchronous with read and write control signals and cannot be driven by a clock independent of a reference clock on the motherboard. The accelerator accordingly includes an integral multiple clock circuit for multiplying a clock frequency on the motherboard by an integral value, a CPU driven by the integral-multiplied clock frequency and including a cache memory, and a timing circuit for making a timing of a control signal output from the CPU to a logic circuit on the motherboard synchronous with a timing of a signal output from the logic circuit to the CPU.

The timing circuit adjusts the timing when the CPU, driven by a high clock frequency, reads data out of a ROM or RAM driven by a low clock frequency. Rise and fall of the clock signal having a low clock frequency always corresponds to rise and fall of the other clock signal having a high clock frequency and is determined by multiplying the low clock frequency by an integral value. Data are read at the timing of the low clock frequency based on the above relationship. The timing circuit accordingly detects a rise of the clock signal having the low clock frequency.

The CPU of the accelerator generally includes a cache memory of several kilobytes to reduce data exchange between the CPU and logic circuits driven by a low clock frequency so as to remarkably speed up the processing. Since programs executed by the CPU in a predetermined time period generally exist in a narrow memory area, the cache memory of several kilobytes on the accelerator reduces the number of accesses of the CPU to the logic circuits to less than one tenth. Data exchange between the CPU and the cache memory is implemented at the high clock frequency of the CPU. The cache memory in the CPU thus significantly speeds up the processing of the whole computer system even when the computer includes a ROM and a RAM driven only by a low clock frequency.

These accelerators are, however, applicable only to integral-multiplied clock frequencies. For example, when a CPU driven by a clock frequency of 20 MHz is replaced by a CPU which can be driven by a maximum clock frequency of 50 MHz, the new CPU cannot work at a speed of 60 MHz which is three times the frequency 20 MHz but works only at a speed of 40 MHz which is twice the frequency 20 MHz. In another example, when a CPU working at the speed of 20 MHz is replaced by a CPU driven by a clock frequency of 33 MHz, the new CPU cannot work at the speed of 40 MHz which is twice the frequency 20 MHz, thereby not realizing the high-speed processing.

"BYTE" magazine of April 1994, in a special report: 'Intel, TI show off the 486DX4', discusses a computer system capable of operating with different CPU's

GB-A-2262415 relates to transactions between logic circuits operating in different timing domains. EP-A-0567711 relates to a data processing system having several clock pulse frequencies. An article by Goodwin et al in "PC World" November 1992, pp. 159-162, discusses upgrading processors by doubling the internal processing speed.

The object of the invention is accordingly to speed up the processing of a computer even when the clock on the accelerator is not an integral multiple of the clock on the CPU.

According to the invention, there is provided an accelerator on a motherboard, for using in place of a first CPU operating on a first clock signal of a first frequency, a second CPU operating on a second clock signal of a second frequency, where said second frequency is a non-integer multiple of said first frequency, and said accelerator further comprises:
clock signal generating means adapted to generate the second clock signal by multiplying the first clock signal by a said non-integer multiple, and outputting the so obtained clock signal as said second clock signal to said second CPU; and
timing signal generating means adapted to generate a timing signal for access of said second CPU in response to each synchronous combination of said first and second clock signals.

The accelerator of the invention thus constructed mounts the second CPU, which works in place of the first CPU on the motherboard. The second CPU is driven by the second clock signal generated by multiplying the first clock signal output to the first CPU by a non-integral value. Since the second clock signal is not an integral multiple of the first clock signal, the second CPU is not directly accessible to other devices on the motherboard. The timing signal generating means thus generates a timing signal for access to/from the second CPU in response to each synchronous combination of the first and second clock signals. The second CPU realizes access to another device on the motherboard with the timing signal.

These and other objects, features, aspects, and advantages of the present invention will become more apparent from the following detailed description of the preferred embodiment, given by way of example only, as illustrated in the accompanying drawings, in which:
Fig. 1 is a block diagram showing an internal structure of a computer with an accelerator 100 embodying the invention;
Fig. 2 is a side elevation illustrating the accelerator 100;
Fig. 3 is a circuit diagram showing a CPU 3 and peripheral circuits mounted on the accelerator 100-
Fig. 4 is a circuit diagram showing a clock multiplication circuit 3a and a timing control circuit 3b of the accelerator 100;
Figs. 5A, 5B, and 5C are logic circuit diagrams showing equivalent circuits of the clock multiplication circuit 3a and the timing control circuit 3b;
Fig. 6 is a timing chart showing the timing of each element in the clock multiplication circuit 3a;
Fig. 7 is a timing chart showing the timing of each element in an address strobe signal generating circuit; and
Fig. 8 is a timing chart of ready signals.

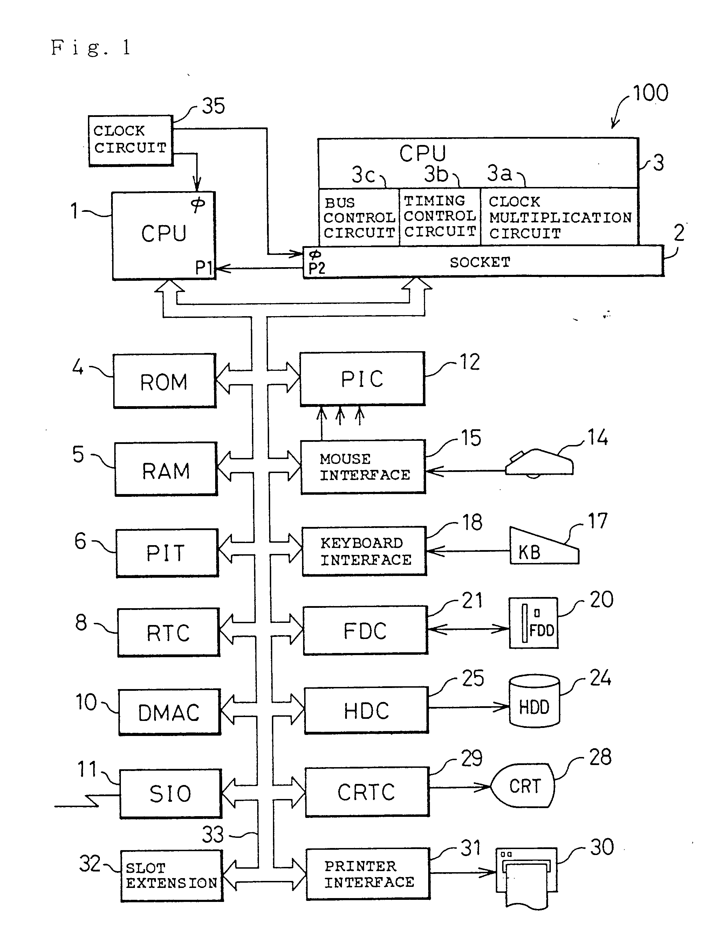

Fig. 1 is a block diagram showing the internal structure of a personal computer generally driven and operated through a CPU 1. An accelerator 100 embodying the invention is inserted into a socket 2 for an arithmetic processor mounted on a motherboard.

Referring to Fig. 1, the computer includes a variety of circuits connected to one another via a bus 33 as well as the CPU 1 originally mounted on the motherboard. These elements are described briefly:
a CPU 1: A central processing unit driven by a clock signal CLK having a clock frequency H1;
a ROM 4: A mask memory for storing monitor programs and other programs;
a RAM 5: a memory whose contents can be read or written and which constitutes a main storage;
a PIT 6: an interval timer for executing a timer interrupt;
an RTC 8: a battery-backed up real time clock for counting the time;
a DMAC 10: a controller for controlling direct memory access without intervention by the CPU 1;
an SI0 11: a serial interface for controlling RS-232C communications;
a PIC 12: an interrupt controller for assigning priorities to a variety of interrupts;
a mouse interface 15: an interface for receiving and outputting data from and to a two-button mouse 14;
a keyboard interface 18: an interface for receiving inputs from a keyboard 17;
an FDC 21: a flexible disk controller for controlling a flexible disk drive (FAD) 20;
an HDC 25: a hard disk controller for controlling a hard disk drive (HAD) 24;
a CRTC 29: a CRT controller for controlling output of signals to a color CRT 28 which displays required data in color;
a printer interface 31: an interface for controlling output of data to a printer 30; and
a clock circuit 35: a logic circuit for generating the clock signal CLK of the clock frequency H1.

An extension slot 32 is further connected to the bus 33 for possible extension.

The CPU 1 has an input port P1, which connects with an output port P2 of the socket 2. When an arithmetic processor or the accelerator 100 is inserted into the socket 2, the output port P2 is internally grounded to output a signal of a low level. When the signal input into the input port P1 falls to the low level, the CPU 1 stops its operation and turns all its output connected to the bus 33 to high impedance. Namely, insertion of the accelerator 100 into the socket 2 leads the CPU 1 to stop its operation and a CPU 3 mounted on the accelerator 100 to start processing in place of the inactivated CPU 1. The CPU 3 on the accelerator 100 executes processing at a higher speed than the CPU 1, and is driven by a clock signal CLK15 having a clock frequency H2 (30 MHz) in this embodiment as described later.

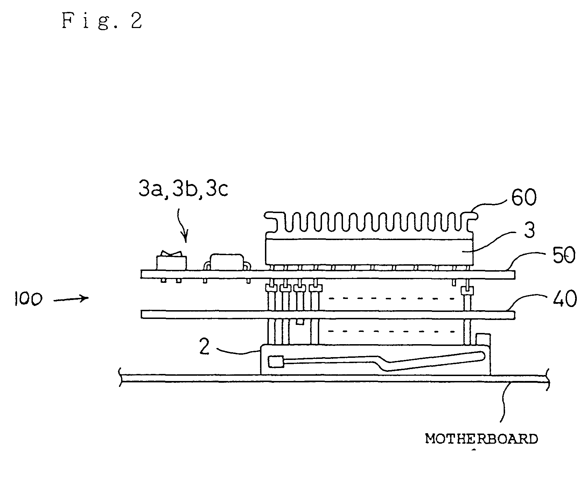

Fig. 2 is a side elevation illustrating the accelerator 100. The accelerator 100 includes a signal conversion board 40 having a plurality of terminal pins which are received by pins in the socket 2 originally prepared for an arithmetic processor on the motherboard, and a circuit board 50 which is disposed above the signal conversion board 40 and on which the CPU 3 and peripheral circuits are mounted. Since the high-speed CPU 3 is inserted into the socket 2 originally prepared for an arithmetic processor, the signal conversion board 40 works to compensate a slight difference (three pins in this embodiment) between the pin arrangement of the CPU 3 and that of the socket 2. In this embodiment, the socket 2 is for an i80487™ (manufactured by Intel Corporation) and the CPU 3 is an i8048DX2™-66 (manufactured by Intel Corporation).

The circuit board 50 mounts the CPU 3 as well as a PLA (programmable logic array), a digital delay line, a resistor, and a jumper wire constituting peripheral circuits described later. A radiation heat sink 60 is further attached to an upper face of the CPU 3.

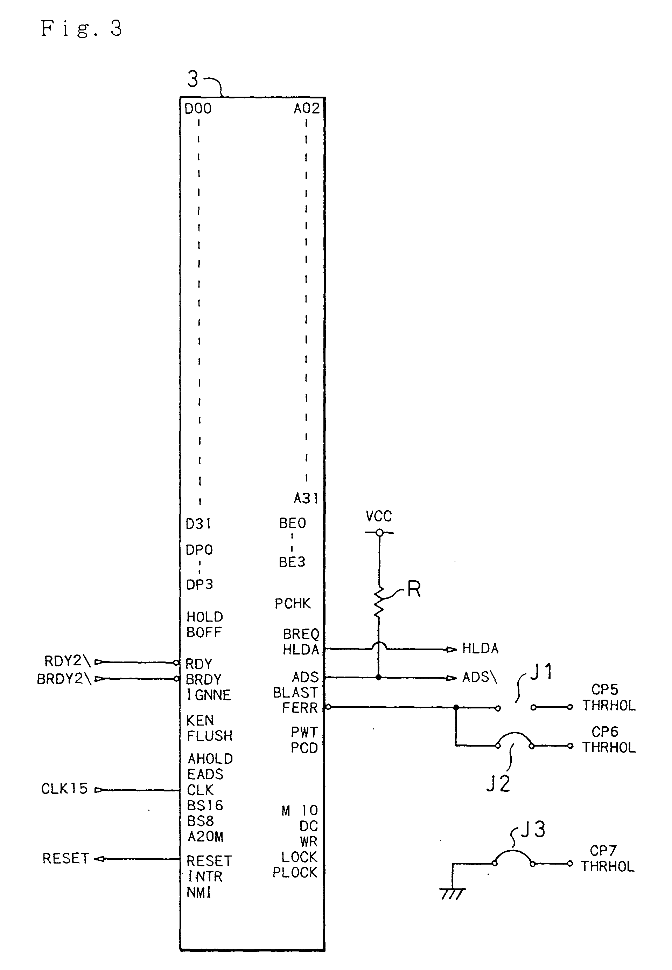

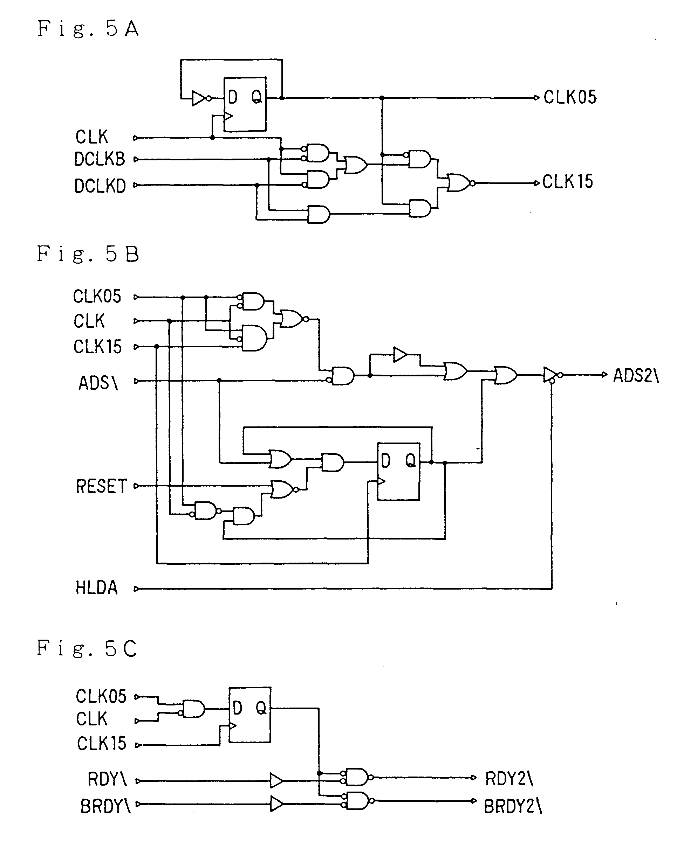

As for the circuit structure, the accelerator 100 includes the high-speed CPU 3, a clock multiplication circuit 3a for converting a clock signal CLK of the clock frequency H1 to another clock signal CLK15 of the clock frequency H2, a timing control circuit 3b for controlling the timing of data exchange with other logic circuits like the ROM 4 and the RAM 5 driven by the clock signal CLK of the clock frequency H1, and a bus control circuit 3c having a control port, an address port, and a data port. These circuits are constructed by logic circuits shown in Figs. 3 and 5.

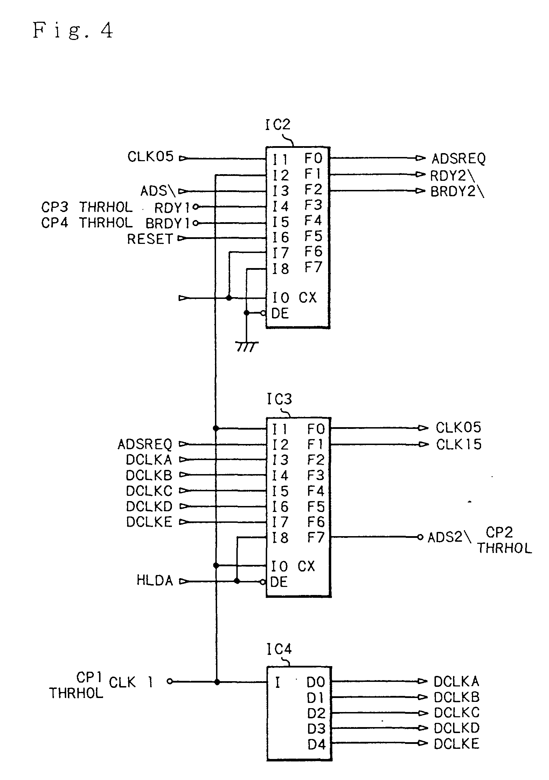

Fig. 3 shows the CPU 3 working as the center of the logic circuits of the accelerator 100 and control signals related to the CPU 3. In this embodiment, a 486DX2™-66 (manufactured by Intel Corporation) having an upper limit of internal operation frequency at 66 MHz is used for the CPU 3. The CPU 3 is a double-speed CPU internally acting at a frequency twice as high as the frequency of the clock signal supplied externally. For example, when a 30 MHz clock signal is supplied to the CPU 3, it works by a 60 MHz clock signal internally. Most input/output pins of the CPU 3 are directly connected to the corresponding signal lines of the bus 33 on the motherboard via the socket 2. Signals converted to different signals or transmitted through different signal lines on the circuit board 50 include an address control signal ADS\ for informing confirmation of a signal on an address bus, a bus hold acknowledge signal HLDA, a ready signal RDY\ representing completion of a bus cycle in a non-burst mode, a burst mode ready signal BRDY\ representing completion of a bus cycle in a burst mode, an error signal FERR\ showing an error in floating-point arithmetic, the clock signal CLK functioning as a standard of processor operations, and a reset signal RESET for resetting the processor. The symbol \ affixed to the signal name represents that the signal is low active. In the drawings of Figs. 3 and 4, 'CPn THRHOL' represents connection with a joint terminal (through hole) to the signal conversion board 40.

Fig. 4 is a circuit diagram showing the clock multiplication circuit 3a and the timing control circuit 3b of the accelerator 100. In this embodiment, the clock frequencies H1 and H2 are respectively set equal to 20 MHz and 30 MHz. One cycle of the clock signal CLK having the clock frequency H1 is accordingly equal to 50 ns; 25 ns for a high level and 25 ns for a low level.

The clock multiplication circuit 3a of the accelerator 100 includes an IC3 and an IC4, the latter of which stores a digital delay line and receives the clock signal CLK at each input port I.

The IC4 receives the clock signal CLK at the input port I, and outputs signals DCLKA through DCLKE, each having a phase delayed by a predetermined time period, from output ports D0 through D4. When the phase difference of each signal output from the IC4 is expressed as a delay time from the clock signal CLK, the signals output from the output port D0 through D4 respectively have delays of 5 ns, 10 ns, 15 ns, 20 ns, and 25 ns.

The signals DCLKA through DCLKE thus generated have the same waveform as the clock signal CLK and delayed from the clock signal CLK by 5 ns, 10 ns, 15 ns, 20 ns, and 25 ns, respectively. These clock signals DCLKA through DCLKE are input into the corresponding input terminals of the IC3.

Both IC2 and IC3 are programmable logic arrays (PLA) having D-type flip flops, which receive a plurality of input signals and generate a desirable output according to the AND-OR logic. In this embodiment, the IC3 divides the frequency of the clock signal CLK to generate a clock signal CLK05 of a half frequency, and receives the clock signals DCLKA through DCLKE output from the IC4 to generate the clock signal CLK15. Figs. 5A through 5C show equivalent circuits realized by the IC2 and IC3.

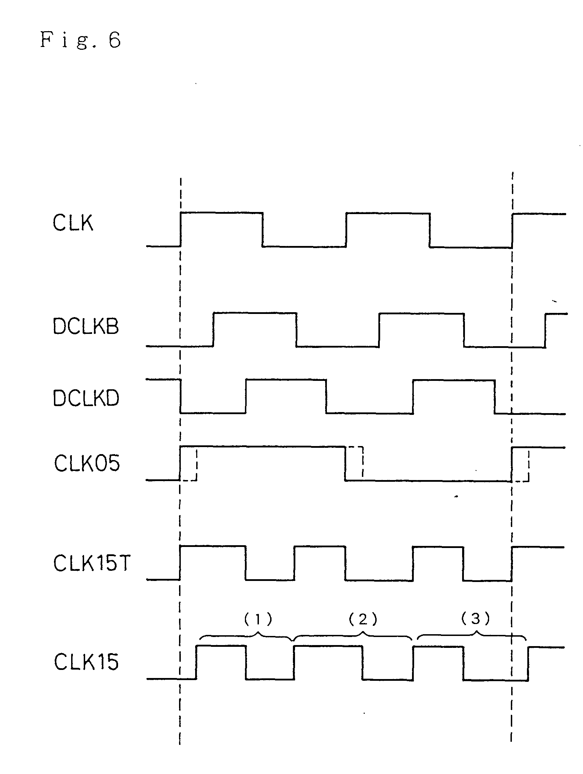

A typical structure of the clock multiplication circuit 3a is described first. Referring to Fig. 5A, the clock signal CLK05 is generated by a circuit which inverts an output of the D-type flip flop driven by the clock signal CLK and inputs the inverted output to data D. The clock signal CLK15 is, on the other hand, generated in response to the clock signals CLK, DCLKB, DCLKD, and CLK05. Waveforms of the respective clock signals are shown in Fig. 6. Provided that no delay is observed in a latch circuit, an AND gate, or an OR gate shown in Fig. 5A, a clock signal CLK15T shown in Fig. 6 is generated. In actual operation, however, since at least a small delay exists at each gate (a relatively large delay for the D-type flip flop), the clock signal CLKO5 and the clock signal CLK15 thus generated have waveforms shown by a broken line and a solid line in Fig. 6, respectively. The clock signal CLK15 has the frequency of 30 MHz, where three cycles of the clock signal CLK15 substantially correspond to two cycles of the clock signal CLK generated from the motherboard. Namely, the clock signal CLK15 has the frequency of 1.5 times the frequency of the clock signal CLK.

The timing control circuit 3b of the accelerator 100 is also constructed by the IC2 and IC3. Figs. 5B and 5C show equivalent circuits realized by the IC2 and IC3 as combinations of logic gates. The timing control circuit 3b works in the following manner to synchronize operation of the motherboard driven by the clock signal CLK with operation of the CPU 3 driven by the clock signal CLK15 which is 1.5 times the clock signal CLK. The timing control circuit 3b generates an address strobe signal ADS2\ output from the CPU 3 to the motherboard as well as a ready signal RDY2\ for. informing the CPU 3 of completion of a bus cycle in a non-burst mode and a burst ready signal BRDY2\ for informing the CPU 3 of completion of a bus cycle in a burst mode.

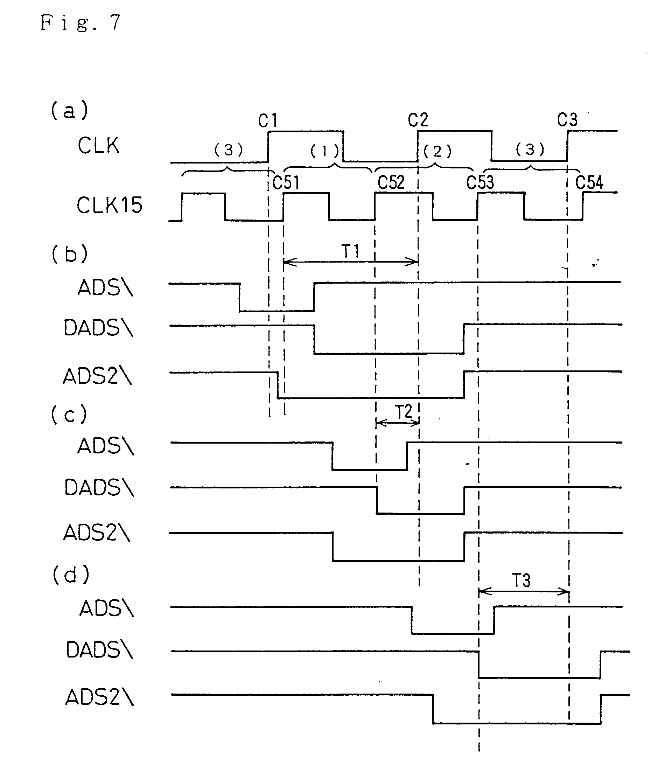

The address strobe signal ADS2\ informs the motherboard of the timing of inputting data on the address bus during access of the CPU 3 to the ROM 4 or the RAM 5 on the motherboard. The address control signal ADS\ is output from the CPU 3 synchronously with the high-speed clock signal CLK15 as shown in Fig. 7. The ROM 4 and the RAM 5 on the motherboard working synchronously with the clock signal CLK confirm a signal on the address bus at a first rise of the clock signal CLK since the address strobe signal has become low active, and determine an address for the access. Direct output of the address control signal ADS\ from the CPU 3 to the motherboard can not make operation of the motherboard synchronous with operation of the CPU 3.

The timing control circuit 3b thus drives the logic circuit shown in Fig. 5B to generate the address strobe signal ADS2\ in response to the address control signal ADS\ output from the CPU 3 and output the address strobe signal ADS2\ to the ROM 4, the RAM 5, and other circuits on the motherboard driven by the clock signal CLK. The clock signal CLK15 on the CPU 3 and the clock signal CLK on the motherboard have an identical phase relationship at every two cycles of the clock signal CLK. The address strobe signals ADS2\ having different timings are thereby generated for the three cycles of the clock signal CLK15.

As shown in Fig. 5B, the address strobe signal ADS2\ is generated from the clock signals CLK, CLK05, and CLK15, the address control signal ADS\, the reset signal RESET, and the bus hold acknowledge signal HLDA. Since the bus hold acknowledge signal HLDA makes a final gate of the address strobe signal ADS2\ inhibitable, the address strobe signal ADS2\ can enter a high impedance condition, like the address port of the CPU 3, when the CPU 3 receives a requirement from another bus master to assign the right of exclusive use of the bus. Except for this condition, the circuit of Fig. 5B is determined according to the relationships between the address control signal ADS\, the address strobe signal ADS2\, and the clock signals CLK and CLK15. The circuit of Fig. 5B is thus described based on the timing of each signal.

For clarifying the relationship between the clock signals CLK and CLK15, three cycles of the clock signal CLK15 obtained after the input of a first clock signal CLK into the delay line IC4 are respectively referred to as the cycle (1), the cycle (2), and the cycle (3) as shown at the bottom of Fig. 6. Completion of the three cycles (1), (2), and (3) of the clock signal CLK15 is accomplished simultaneously with completion of two cycles of the clock signal CLK. There are three, and only three different patterns in the phase relationship between the clock signals CLK15 and CLK, which respectively correspond to the cycles (I), (2), and (3).

In the timing chart of Fig. 7, when a bus cycle starts in the cycle (3), the CPU 3 determines an address at a first rise C51 of the clock signal CLK15, indicated by signal DADS\ in Fig. 7(b). When the address control signal ADS\ is output directly to the motherboard, however, the ROM 4 and the RAM 5 on the motherboard read the address at a first rise C1 of the clock signal CLK, when the address has not been determined yet. As shown in Figs. 7(a) and 7(b), the logic circuit of Fig. 5B makes the start of the address strobe signal ADS2\ output to the motherboard immediately after the first rise C1 of the clock signal CLK, and thereby delays the end of the address strobe signal ADS2\ to a next rise C2 of the clock signal CLK.

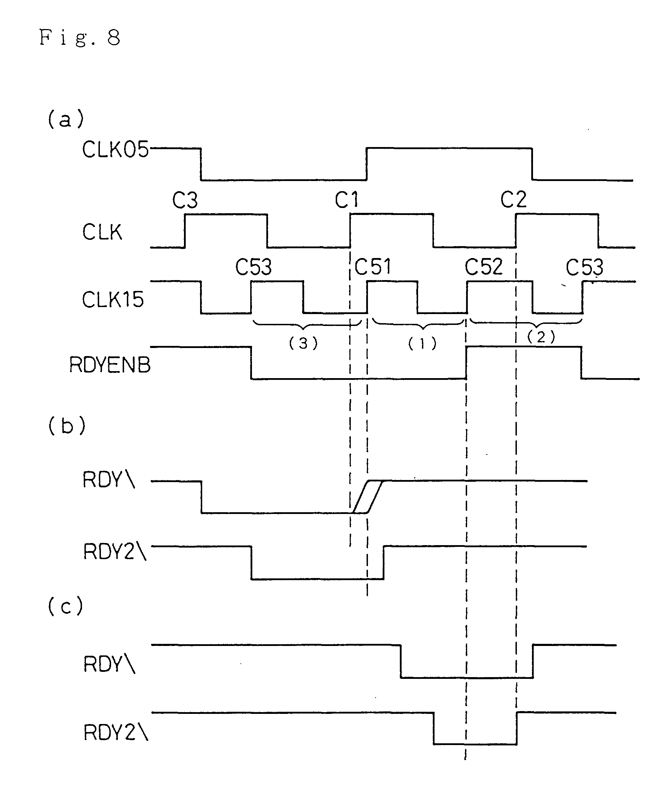

The CPU 3 continues outputting the address from the address port during a wait time T1 between the first rise C51 of the clock signal CLK15 and the second rise C2 of the clock signal CLK. The ready signal RDY\ for informing the CPU 3 of completion of the bus cycle is also adjusted to be a ready signal RDY2\ as shown in Fig. 8.

When a bus cycle starts in the cycle (1), on the other hand, the CPU 3 determines an address at a next rise C52 of the clock signal CLK15 as shown by signal DADS\ in Fig. 7(c). In such a case, no problems arise when the ROM 4 and the RAM 5 on the motherboard read the address at the second rise C2 of the clock signal CLK. The logic circuit of Fig. 5B thus makes the address strobe signal ADS2\ low active simultaneously with a fall of the address control signal ADS\ and continues the low active address strobe signal ADS2\ to the next rise C2 of the clock signal CLK as shown in Fig. 7(c). In this case, the wait time is T2 between the second rise C52 of the clock signal CLK15 and the second rise C2 of the clock signal CLK.

When a bus cycle starts in the cycle (2), the CPU 3 determines an address at a third rise C53 of the clock signal CLK15 as shown by signal DADS\ in Fig. 7(d), whereas the ROM 4 and the RAM 5 on the motherboard read the address at a third rise C3 of the clock signal CLK. The logic circuit of Fig. 5B thus starts the address strobe signal ADS2\ immediately after the address control signal ADS\ becomes low active, and continues the low active address strobe signal ADS2\ to the third rise C3 of the clock signal CLK as shown in Fig. 7(d). In this case, the wait time is T3 between the third rise C53 of the clock signal CLK15 and the third rise C3 of the clock signal C3.

The timing of the control signal output to the ROM 4, the RAM 5, and other logic circuits on the motherboard driven by the clock signal CLK is limited to the three patterns described above since the clock frequency H2 of the clock signal CLK15 is 1.5 times the frequency H1 of the clock signal CLK. Output of the address strobe signal to the motherboard is thus varied according to the position where a bus cycle starts in the phase relationship between the two clock signals CLK15 and CLK. Addresses, data, and other signals output from the output port of the CPU 3 are accordingly recognized securely by the logic circuit on the motherboard driven by the clock signal CLK.

The bus cycle of the CPU 3 should be extended in response to the output of the address strobe signal. The ready signal RDY\ for informing completion of a bus cycle in the non-burst mode or the burst ready signal BRDY\ for informing completion of a bus cycle in the burst mode are thereby replaced respectively by a ready signal RDY2\ and a burst ready signal BRDY2\ as shown in Fig. 8. The logic circuit of Fig. 5C implements this conversion. More specifically, the circuit of Fig. 5C generates the ready signals RDY2\ and the BRDY2\ from the ready signals RDY\ and BRDY\ output from the motherboard and the clock signals CLK and CLK15. The CPU 3 receives the ready signals RDY2\ and the BRDY2\ at the corresponding terminals as shown in Fig. 3.

The accelerator 100 of the embodiment drives the CPU 3 by the clock signal CLK15 having the frequency 1.5 times the frequency of the clock signal CLK on the motherboard. This realizes high-speed processing of the computer even when the maximum frequency of the CPU 3 on the accelerator 100 is not an integral multiple of the clock frequency on the motherboard. Since the CPU 3 is a double-speed CPU in this embodiment, the actual operation speed is equal to 60 MHz (=20x1.5x2), which is three times the speed 20 MHz of the CPU 1.

In this embodiment, three jumper wires J1, J2, and J3 are mounted on the circuit board 50 to be applicable to the insertion of the accelerator 100 into the socket 2 for an arithmetic processor as well as the replacement of the accelerator 100 for the CPU 1. When the accelerator 100 is replaced for the CPU 1, the accelerator 100 is mounted directly on the socket for the CPU 1 by connecting the jumper wire J1 instead of the jumper wires J2 and J3 and removing the signal conversion board 40.

There may be many modifications, alternations, and changes without departing from the scope of essential characteristics of the invention. It is thus clearly understood that the above embodiment is only illustrative and not restrictive in any sense. The principle of the invention is applicable to other structures: for example, a structure where the frequency of the clock signal is multiplied by another non-integral value such as 2.5 times; a structure where the timing control circuit 3b is realized by a gate array; a structure where the clock multiplication circuit 3a is realized by a PLL circuit; and a structure where the CPU on the accelerator is not a double-speed CPU but a standard CPU having the operation speed of 60 MHz and the CPU on the motherboard has the operation speed of 40 MHz.

The scope of the present invention is limited only by the terms of the appended claims.

## Claims

1. An accelerator (100) on a motherboard, for using in place of a first CPU (1) operating on a first clock signal of a first frequency, a second CPU (3) operating on a second clock signal of a second frequency, **characterised in that** said second frequency is a non-integer multiple of said first frequency, and **in that** said accelerator further comprises:
clock signal generating means (3a) adapted to generate the second clock signal by multiplying the first clock signal by a said non-integer multiple, and outputting the so obtained clock signal as said second clock signal to said second CPU (3); and
timing signal generating means (3b) adapted to generate a timing signal, for access of said second CPU (3), in response to each synchronous combination of said first and second clock signals.

2. An accelerator as claimed in claim 1, wherein said clock signal generating means comprises a circuit for multiplying said first clock signal by 1.5 times.

3. An accelerator as claimed in claim 1 or 2, wherein said second CPU comprises a double-speed CPU having an internal operation clock running at a speed twice as high as the second frequency of said second clock signal input to said second CPU.

4. An accelerator as claimed in claim 1, 2 or 3 said accelerator further comprising a converter (40) for converting the pin arrangement of said second CPU to the pin arrangement of another CPU designed for use as a coprocessor to said first CPU.

## Patentansprüche

1. Beschleunigungsvorrichtung (100) auf einer Hauptplatine zur Verwendung anstelle einer ersten Zentralrecheneinheit (1), die mit einem ersten Taktsignal einer ersten Frequenz arbeitet, wobei eine zweite Zentralrecheneinheit (3) mit einem zweiten Taktsignal einer zweiten Frequenz arbeitet, **dadurch gekennzeichnet, daß** die zweite Frequenz ein nicht ganzzahliges Vielfaches der ersten Frequenz ist und daß die Beschleunigungsvorrichtung weiterhin aufweist:
taktsignalerzeugende Mittel (3a), die ausgelegt sind, um das zweite Taktsignal durch Multiplizieren des ersten Taktsignals mit dem nicht ganzzahligen Vielfachen zu erzeugen und die das so erhaltene Taktsignals als das zweite Taktsignal zu der zweiten Zentralrecheneinheit (3) ausgeben, und
zeitsignalerzeugende Mittel (3b), die ausgelegt sind, um ein Zeitsignal für einen Zugriff auf bzw. von der zweiten Zentralrecheneinheit als Reaktion auf jede synchrone Kombination des ersten und des zweiten Taktsignals zu erzeugen.

2. Beschleunigungsvorrichtung nach Anspruch 1, bei der das taktsignalerzeugende Mittel einen Schaltkreis zum Multiplizieren des ersten Taktsignals mit 1,5 aufweist.

3. Beschleunigungsvorrichtung nach Anspruch 1 oder 2, bei der die zweite Zentralrecheneinheit eine Zentralrecheneinheit mit doppelter Geschwindigkeit aufweist, die eine interne Betriebsuhr hat, die mit einer Geschwindigkeit läuft, die doppelt so hoch ist wie die zweite Frequenz des zweiten Taktsignaleingangs zu der zweiten Zentralrecheneinheit.

4. Beschleunigungsvorrichtung nach Anspruch 1, 2 oder 3, wobei die Beschleunigungsvorrichtung weiterhin einen Konverter (40) zum Konvertieren der Anschlußanordnung der zweiten Zentralrecheneinheit zu der Anschlußanordnung einer weiteren Zentralrecheneinheit hat, die zur Verwendung als ein Co-Prozessor für die erste Zentralrecheneinheit entworfen ist.

## Revendications

1. Accélérateur (100) sur une carte-mère, pour utilisation à la place d'une première unité centrale (1) fonctionnant sur un premier signal d'horloge d'une première fréquence, une seconde unité centrale (3) fonctionnant sur un second signal d'horloge d'une seconde fréquence, **caractérisé en ce que** ladite seconde fréquence n'est pas un multiple entier de ladite première fréquence, et **en ce que** ledit accélérateur comprend, en outre :
un moyen de génération de signal d'horloge (3a) conçu pour générer le second signal d'horloge en multipliant le premier signal d'horloge par ledit multiple non-entier et pour sortir le signal d'horloge ainsi obtenu comme ledit second signal d'horloge vers ladite seconde unité centrale (3) ; et
un moyen de génération de signal de cadencement (3b) conçu pour générer un signal de cadencement, pour accès de ladite seconde unité centrale (3) en réponse à chaque combinaison synchrone desdits premier et second signaux d'horloge.

2. Accélérateur selon la revendication 1, dans lequel ledit moyen de génération de signal d'horloge comprend un circuit pour multiplier ledit premier signal d'horloge par 1,5 fois.

3. Accélérateur selon la revendication 1 ou 2, dans lequel ladite seconde unité centrale comprend une unité centrale à double vitesse ayant une fréquence de fonctionnement interne qui est égale à une vitesse deux fois aussi élevée que la seconde fréquence dudit second signal d'horloge entré dans ladite seconde unité centrale.

4. Accélérateur selon la revendication 1, 2 ou 3, ledit accélérateur comprenant, en outre, un convertisseur (40) pour convertir la disposition des broches de ladite seconde unité centrale en la disposition des broches d'une autre unité centrale conçue pour utilisation comme co-processeur de ladite première unité centrale.
